# FASCICULE DE BREVET EUROPEEN

(11) **EP 3 080 812 B1**
(45) Date de publication et mention de la délivrance du brevet: **01.08.2018**
(21) Numéro de dépôt: 14812468.8
(22) Date de dépôt: 12.12.2014
(51) Int. Cl.: G11C 7/10, G06F 11/10, G11C 8/16, G11C 13/00

(54) **SYSTEME D'ECRITURE DE DONNEES DANS UNE MÉMOIRE**
SCHALTUNG ZUM SPEICHERN VON DATEN IN EINEM SPEICHER
MEMORY DATA WRITING CIRCUIT

(30) Priorité: 12.12.2013 FR 1362469
(43) Date de publication de la demande: 19.10.2016
(73) Titulaire: Commissariat à l'Energie Atomique et aux Energies Alternatives, 75015 Paris (FR)
(72) Inventeur: HARRAND, Michel, F-38120 Saint Egreve (FR)
(74) Mandataire: Cabinet Beaumont
(86) Numéro de dépôt international: PCT/EP2014/077651
(87) Numéro de publication internationale: WO 2015/086845

(56) Documents cités:
- US-A1- 2010 080 071
- US-A1- 2010 103 723
- US-A1- 2011 085 398
- US-A1- 2011 185 259

## Description

### Domaine

La présente demande concerne le domaine des mémoires électroniques.

### Exposé de l'art antérieur

Dans la présente demande, on désigne par mémoire, dispositif mémoire, ou mémoire électronique un dispositif comportant une pluralité de cellules élémentaires de mémorisation, chaque cellule pouvant être programmée pour stocker un ou plusieurs bits de données. En pratique, une mémoire peut contenir un très grand nombre de cellules élémentaires, typiquement plusieurs millions à plusieurs centaines de milliards.

On s'intéresse en particulier aux mémoires dites résistives, c'est-à-dire dans lesquelles chaque cellule élémentaire de mémorisation comprend un élément dont on peut modifier la résistance en lui appliquant une tension de polarisation. Parmi les mémoires résistives les plus répandues, on peut notamment citer :
les mémoires à changement de phase, généralement désignées dans la technique par l'acronyme PCM (de l'anglais "Phase Change Memory"), dans lesquelles l'élément résistif est réalisé à l'aide d'un matériau dont on peut changer l'état cristallin et par conséquent la résistivité, en faisant varier sa température pendant l'écriture;
les mémoires à pont conducteur, généralement désignées dans la technique par l'acronyme CBRAM (de l'anglais "Conductive Bridge Random Access Memory"), dans lesquelles l'élément résistif est réalisé à l'aide d'un matériau isolant dans lequel un filament conducteur peut être créé ou supprimé par application d'une tension de polarisation ; et
les mémoires à oxydation-réduction, généralement désignées dans la technique par l'acronyme OxRRAM (de l'anglais "Oxyde-based Resistive Random Access Memory"), dans lesquelles l'élément résistif est aussi réalisé à l'aide d'un matériau isolant dans lequel un filament conducteur peut être créé ou supprimé par application d'une tension de polarisation.

Un inconvénient des mémoires résistives est qu'elles ont une durée de vie ou endurance relativement faible. A titre d'exemple illustratif, le nombre d'écritures que peut typiquement supporter une cellule élémentaire d'une mémoire résistive est de l'ordre de 10⁸, alors que ce nombre est quasiment infini, par exemple de l'ordre de 10¹⁶, pour une cellule d'une mémoire capacitive volatile de type DRAM.

Un autre inconvénient des mémoires résistives réside dans le fait que l'écriture d'un bit dans une cellule de la mémoire nécessite une quantité d'énergie électrique relativement importante.

Pour augmenter la durée de vie d'une mémoire de type PCM et réduire sa consommation électrique, il a été proposé, dans l'article intitulé "A Durable and Energy Efficient Main Memory Using Phase Change Memory Technology" de Ping Zhou et al., à chaque opération d'écriture d'une nouvelle donnée dans la mémoire, de commencer par lire la donnée contenue dans la zone de la mémoire que l'on souhaite écrire, puis d'écrire dans la mémoire uniquement les bits de la nouvelle donnée dont la valeur diffère des bits de l'ancienne donnée. L'usure de la mémoire et l'énergie électrique consommée lors d'une étape de lecture étant relativement faibles par rapport à l'usure de la mémoire et à l'énergie électrique consommée lors d'une étape d'écriture, ceci permet d'augmenter la durée de vie de la mémoire et de diminuer sa consommation électrique en évitant des écritures redondantes.

Toutefois, un inconvénient de cette solution est que l'étape de lecture qui précède chaque étape d'écriture lors d'une opération d'écriture dans la mémoire, entraine une augmentation non négligeable des temps d'écriture dans la mémoire.

D'autres exemples de circuits mémoires ont été proposés dans les documents US2010/103723, US2011/085398, US2010/080071 et US2011/185259. Le document US210/103723 décrit les caractéristiques du préambule de la revendication 1.

### Résumé

Ainsi, un mode de réalisation prévoit un système défini par la revendication 1. Selon un mode de réalisation, le circuit de contrôle est en outre adapté, à chaque opération de lecture ou d'écriture dans une page de la première mémoire : à déterminer si le quatrième champ de la ligne d'adresse correspondant à l'adresse de la page visée est à un état valide ; et/ou à comparer le contenu du premier champ de ladite ligne à l'adresse de la portion contenant la page visée.

Selon un mode de réalisation, la première mémoire est une mémoire résistive.

Selon un mode de réalisation, pour effectuer des première et deuxième opérations d'écriture consécutives dans des première et deuxième pages de portions distinctes de la première mémoire, le circuit de contrôle est adapté à, successivement : lire une première ancienne donnée dans la première page via le premier port et écrire cette donnée dans la deuxième mémoire ; lire une deuxième ancienne donnée dans la deuxième page via le premier port et écrire cette donnée dans la deuxième mémoire, et, simultanément, écrire une première nouvelle donnée dans la première page via le deuxième port en tenant compte de la première ancienne donnée ; et écrire une deuxième nouvelle donnée dans la deuxième page via le deuxième port en tenant compte de la deuxième ancienne donnée.

Selon un mode de réalisation, la deuxième mémoire est une mémoire SRAM.

Selon un mode de réalisation, chaque page de la première mémoire comprend plusieurs cellules élémentaires de stockage de données, et le circuit de contrôle est adapté, à chaque opération d'écriture d'une nouvelle donnée dans une page de la première mémoire, lors de l'étape d'écriture de cette opération d'écriture, à comparer l'ancienne donnée lue dans la page et la nouvelle donnée, et à écrire uniquement dans les cellules de la page dont le contenu doit être modifié pour enregistrer la nouvelle donnée.

Selon un mode de réalisation, chaque page de la première mémoire comprend au moins des premier et deuxième mots comportant chacun une ou plusieurs cellules élémentaires de stockage de données, et un ensemble d'une ou plusieurs cellules élémentaires de stockage de données adapté à contenir un code de correction d'erreur protégeant des données contenues dans les premier et deuxième mots.

Selon un mode de réalisation, le circuit de contrôle est adapté, à chaque opération d'écriture dans une page de la mémoire, à lire dans la page une ancienne donnée comportant les contenus des premier et deuxième mots de la page et le code de correction d'erreur les protégeant, à corriger si nécessaire les contenus des premier et deuxième mots à l'aide du code de correction d'erreur, à remplacer dans l'ancienne donnée le contenu d'au moins un des premier et deuxième mots par la nouvelle donnée utilisateur, à recalculer le code de correction d'erreur pour tenir compte de la nouvelle donnée utilisateur, puis à écrire dans la page la nouvelle donnée et le nouveau code de correction d'erreur.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 représente de façon schématique et partielle un exemple d'un mode de réalisation d'un système comportant une mémoire et des moyens permettant d'effectuer des opérations d'écriture dans la mémoire ;
la figure 2 représente de façon plus détaillée un exemple de réalisation de la mémoire du système de la figure 1 ; et
la figure 3 représente un autre exemple de réalisation de la mémoire du système de la figure 1.

### Description détaillée

Par souci de clarté, de mêmes éléments ont été désignés par de mêmes références aux différentes figures. En outre, seuls les éléments utiles à la compréhension des modes de réalisation décrits ont été représentés et seront détaillés par la suite.

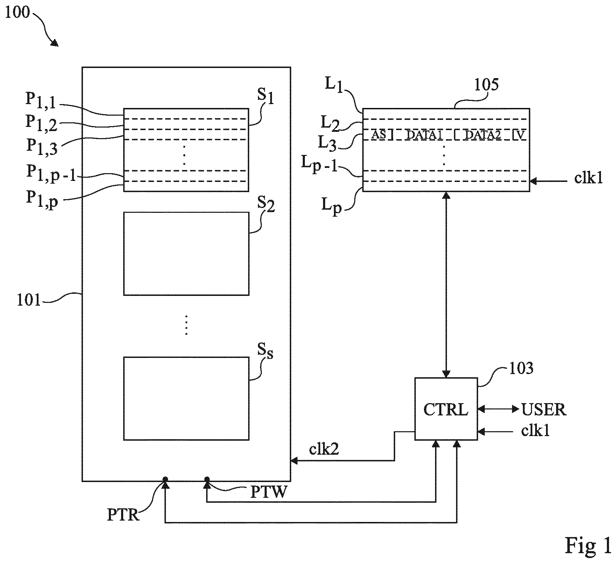

La figure 1 représente de façon schématique et partielle un exemple d'un mode de réalisation d'un système 100 comportant une mémoire 101, par exemple une mémoire résistive, et des moyens permettant d'effectuer des opérations d'écriture dans la mémoire 101.

La mémoire 101 comprend une pluralité de cellules élémentaires (non représentées) réparties en plusieurs portions ou segments Sᵢ, avec i entier allant de 1 à s et s entier supérieur à 1. Les cellules élémentaires de chaque portion Sᵢ sont réparties en une ou plusieurs pages P_{i,j}, avec j entier allant de 1 à p et p entier supérieur ou égal à 1, de plusieurs cellules chacun. Dans cet exemple, une page correspond à la plus grande quantité de mémoire adressable en lecture ou en écriture en un seul cycle mémoire, c'est-à-dire au plus grand groupe de cellules élémentaires qui peut être lu ou écrit en un seul cycle dans la mémoire.

A titre d'exemple illustratif non limitatif, la mémoire 101 est une mémoire de 1 giga-bits, organisée en 512 segments, chaque segment comportant 4096 pages de 64 octets chacune.

Selon un aspect du mode de réalisation de la figure 1, la mémoire 101 a une architecture permettant d'accéder en même temps en lecture à une première page de la mémoire et en écriture à une deuxième page de la mémoire, à condition que les première et deuxième pages appartiennent à des portions Sᵢ distinctes de la mémoire. Dans cet exemple, la mémoire 101 comprend un premier port d'accès PTR permettant d'accéder en lecture aux pages de la mémoire, et un deuxième port d'accès PTW permettant d'accéder en écriture aux pages de la mémoire, les ports PTR et PTW permettant d'adresser simultanément, c'est-à-dire lors d'un même cycle mémoire, deux pages Sᵢ de portions distinctes de la mémoire. A chaque cycle de fonctionnement de la mémoire 101, il est ainsi possible de lire dans une page d'une portion de la mémoire 101 via le port PTR, et d'écrire dans une page d'une autre portion de la mémoire 101 via le port PTW.

Le système 100 comprend en outre un circuit de contrôle 103 (CTRL), comportant par exemple un microcontrôleur ou un circuit spécifique utilisant par exemple une machine à états finis. Le circuit 103 est adapté à recevoir des requêtes d'accès à la mémoire provenant d'un utilisateur (USER) de la mémoire, et à répondre à ces requêtes, en accédant pour cela aux pages P_{i,j} de la mémoire via ses ports d'accès PTR et PTW. Le circuit 103 est notamment adapté à effectuer des opérations d'écriture dans des pages de la mémoire, chaque opération d'écriture dans une page P_{i,j} de la mémoire comportant une étape de lecture d'une ancienne donnée contenue dans la page P_{i,j} via le port PTR, suivie d'une étape d'écriture d'une nouvelle donnée dans la page P_{i,j} via le port PTW en tenant compte de l'ancienne donnée.

A titre d'exemple, lors d'une opération d'écriture dans une page P_{i,j}, le circuit 103 commence par lire l'ancienne donnée contenue dans la page P_{i,j}, compare cette ancienne donnée avec la nouvelle donnée fournie par l'utilisateur, puis écrit dans la page P_{i,j} uniquement les bits de la nouvelle donnée qui diffèrent des bits de l'ancienne donnée. Pour cela, à titre d'exemple non limitatif, un OU EXCLUSIF peut être réalisé bit à bit entre l'ancienne donnée et la nouvelle donnée. Pour chaque bit de la page adressée, si le résultat du OU EXCLUSIF est un 1, cela signifie que la valeur que l'on souhaite écrire est différente de la valeur déjà contenue à la même position dans la page. Dans ce cas, l'amplificateur d'écriture de la cellule correspondante est commandé pour écrire la nouvelle valeur dans la cellule. Si au contraire, le résultat du OU EXCLUSIF est un 0, cela signifie que la valeur que l'on souhaite écrire est identique à la valeur déjà contenue à la même position dans la page. Dans ce cas, l'amplificateur d'écriture de la cellule correspondante est bloqué ou désactivé, et l'opération d'écriture n'est pas effectuée. En pratique, la nouvelle donnée fournie par l'utilisateur peut être appliquée sur une entrée de données de la mémoire, et le résultat du OU EXCLUSIF entre l'ancienne donnée et la nouvelle donnée peut être appliqué en même temps sur une entrée de commande des amplificateurs d'écriture de la mémoire. Ceci permet de supprimer des écritures de cellule redondantes et ainsi d'augmenter la durée de vie de la mémoire et/ou de réduire sa consommation électrique, en particulier si la mémoire est une mémoire s'usant plus lorsqu'elle est écrite que lorsqu'elle est lue, et/ou si la mémoire consomme plus d'énergie lorsqu'elle est écrite que lorsqu'elle est lue.

Un avantage du système 100 de la figure 1 résulte du fait que les étapes de lecture et d'écriture d'une même opération d'écriture sont effectuées via des ports PTR et PTW distincts de la mémoire. Ceci permet, du point de vue de l'utilisateur, de diminuer les temps d'accès aux données de la mémoire par rapport aux systèmes existants. En effet, lorsqu'une opération d'écriture requise par l'utilisateur est réalisée par le circuit de contrôle 103, le circuit 103 peut :
lors d'un premier cycle mémoire, effectuer l'étape de lecture de l'opération d'écriture via le port PTR et effectuer, via le port PTW, une étape d'écriture d'une autre opération, par exemple une étape d'écriture d'une opération d'écriture précédente ; et
lors d'un deuxième cycle mémoire, effectuer l'étape d'écriture de l'opération d'écriture via le port PTW et effectuer, via le port PTR, une étape de lecture d'une autre opération, par exemple une étape de lecture d'une opération d'écriture suivante. Ainsi, bien qu'une opération d'écriture s'effectue en deux cycles mémoire, le système 100 de la figure 1 permet, du point de vue de l'utilisateur, de traiter une opération d'écriture par cycle mémoire, la durée du cycle mémoire étant conditionnée par le plus long des temps de lecture et d'écriture dans la mémoire.

Dans l'exemple de la figure 1, pour gérer les accès utilisateurs consécutifs à une même portion Sᵢ de la mémoire 101, le système 100 comprend, en plus de la mémoire 101, une mémoire tampon 105 dans laquelle le circuit de contrôle 103 peut lire et écrire. La mémoire 105 est adaptée à mémoriser une table de p lignes Lⱼ, avec j entier allant de 1 à p et p entier supérieur ou égal à 1, c'est-à-dire une table comportant un nombre de lignes Lⱼ égal au nombre de pages P_{i,j} dans chaque segment Sᵢ de la mémoire 101. Dans cet exemple, chaque ligne Lⱼ de la mémoire tampon 105 comprend un premier sous-ensemble de bits ou champ AS pouvant contenir une adresse d'un segment de la mémoire 101, un deuxième sous-ensemble de bits ou champ DATA1, par exemple de la taille d'une page P_{i,j} de la mémoire 101, pouvant contenir une première donnée lue ou à écrire dans une page de la mémoire 101, un troisième sous-ensemble de bits ou champ DATA2, par exemple de la taille d'une page P_{i,j} de la mémoire 101, pouvant contenir une deuxième donnée lue ou à écrire dans une page de la mémoire 101, et un bit ou champ de validité V indiquant si les champs AS, DATA1 et DATA2 de la ligne P'ⱼ contiennent ou non des valeurs valides.

La mémoire 105 peut être une mémoire de technologie différente de la mémoire 101, par exemple une mémoire présentant des temps d'accès en lecture et en écriture plus courts que la mémoire 101, par exemple une mémoire SRAM (de l'anglais "Static Random Access Memory" - mémoire statique à accès aléatoire).

A titre d'exemple, la mémoire 105 et le circuit de contrôle 103 d'une part, et la mémoire 101 d'autre part, peuvent être cadencés par des horloges de fréquences différentes. Dans l'exemple représenté, la mémoire 105 et le circuit de contrôle 103 reçoivent un premier signal d'horloge clk1 d'une première fréquence, et la mémoire 101 reçoit un deuxième signal d'horloge clk2 de fréquence inférieure au premier signal clk1, le signal clk2 étant généré par le circuit de contrôle 103 par division fréquentielle du signal clk1. A titre de variante, le signal d'horloge rapide clk1 peut être généré par multiplication fréquentielle du signal d'horloge lent clk2 utilisé pour cadencer la mémoire 101, par exemple à l'aide d'une boucle à verrouillage de phase.

Un exemple (non limitatif) de fonctionnement du système 100 de la figure 1 va maintenant être décrit.

A l'initialisation du système 100, tous les champs de validité V de la mémoire tampon 105 sont initialisés à un état invalide.

Lorsqu'une opération d'écriture dans une page P_{i,j} de la mémoire 101 est requise par l'utilisateur, le circuit de contrôle 103 consulte la table de lignes Lⱼ de la mémoire tampon 105, à l'adresse correspondant à l'adresse page de la requête utilisateur, c'est-à-dire qu'il consulte la ligne Lⱼ de même rang j dans la table de la mémoire 105 que la page P_{i,j} dans le segment Sᵢ. A titre de variante, les adresses ligne et les adresses page ne sont pas identiques, mais il existe en tout état de cause une transformation bijective entre les adresses ligne et les adresses page, c'est-à-dire que chaque adresse ligne est associée à une et une seule adresse page, et réciproquement.

Si le champ de validité V de la ligne Lⱼ est à un état valide, le circuit de contrôle 103 vérifie si le champ d'adresse de segment AS de la ligne Lⱼ contient la même adresse de segment que la requête utilisateur.

Si le champ de validité V de la ligne Lⱼ est à un état valide et si le champ AS de la ligne Lⱼ contient une adresse de segment différente de celle de la requête utilisateur, le circuit de contrôle 103 détermine, en tenant compte des données contenues dans les champs DATA1 (ancienne donnée) et DATA2 (nouvelle donnée) de la ligne Lⱼ, la donnée qu'il convient d'écrire dans la page P_{i',j} de la mémoire 101 dont l'adresse est définie par l'adresse segment contenue dans le champ AS de la donnée Lⱼ et par l'adresse page de la requête utilisateur, puis écrit cette donnée dans la page P_{i',j} via le port PTW (i' étant le rang du segment dont l'adresse est contenue dans le champ AS de la ligne Lⱼ).

Dans le cas où le système 100 met en oeuvre le mécanisme de réduction d'usure susmentionné, la donnée écrite dans la page P_{i',j} est la donnée contenue dans le champ DATA2 sans modification, mais seuls les bits de cette donnée qui diffèrent de la donnée contenue dans le champ DATA1 sont effectivement écrits. Pour cela, le signal de commande à appliquer aux amplificateurs d'écriture de la mémoire 101 est calculé en exécutant un OU EXCLUSIF bit à bit entre les données contenues dans les champs DATA1 et DATA2. Le résultat du OU EXCLUSIF est envoyé à la mémoire 101 en même temps que la donnée DATA2.

Parallèlement à cette étape d'écriture, le circuit de contrôle 103 lit la donnée contenue dans la page P_{i,j} de la mémoire 101, écrit cette donnée dans le champ DATA1 de la ligne Lⱼ, écrit la nouvelle donnée utilisateur (contenue dans la requête utilisateur) dans le champ DATA2 de la ligne Lⱼ, et écrit l'adresse segment de la requête utilisateur dans le champ AS de la ligne Lⱼ.

Si le champ de validité V de la ligne Lⱼ est à un état valide et si le champ AS de la ligne Lⱼ contient la même adresse de segment que la requête utilisateur, le circuit de contrôle 103 écrit directement dans le champ DATA2 de la ligne Lⱼ, la nouvelle donnée utilisateur à écrire dans la page P_{i,j}. Dans ce cas, le traitement de l'opération d'écriture ne comprend pas d'étape de lecture d'une ancienne donnée dans la page P_{i,j} de la mémoire 101, cette ancienne donnée étant déjà contenue dans le champ DATA1 de la ligne Lⱼ.

Si le champ de validité V de la ligne Lⱼ est à un état invalide, le circuit de contrôle 103 lit la donnée contenue dans la page P_{i,j} de la mémoire 101, écrit cette donnée dans le champ DATA1 de la ligne Lⱼ, écrit la nouvelle donnée utilisateur dans le champ DATA2 de la ligne Lⱼ, écrit l'adresse segment de la requête utilisateur dans le champ AS de la ligne Lⱼ, et met le champ de validité V de la donnée de la ligne Lⱼ à l'état valide.

On notera que dans cet exemple, l'étape de détermination de la donnée à écrire dans une page P_{i,j} de la mémoire, en tenant compte de l'ancienne donnée contenue dans cette page et de la nouvelle donnée fournie par l'utilisateur, est effectuée juste avant l'étape d'écriture de la nouvelle donnée dans la page P_{i,j}. A titre de variante, cette étape peut être réalisée plus en amont, juste après la lecture de l'ancienne donnée contenue dans la page P_{i,j}. En particulier, dans l'exemple de fonctionnement susmentionné, on peut, au lieu d'écrire la nouvelle donnée utilisateur dans le champ DATA2 de la ligne Lⱼ (après avoir lu l'ancienne donnée contenue dans la page P_{i,j}), combiner l'ancienne donnée et la nouvelle donnée et écrire directement le résultat de cette combinaison dans le champ DATA2 de la ligne Lⱼ, ou écrire la nouvelle donnée et le résultat de la combinaison (par exemple le résultat du OU EXCLUSIF entre l'ancienne et la nouvelle donnée) dans le champ DATA2 dans le cas où le mécanisme de réduction d'usure susmentionné est mis en oeuvre.

On notera que dans ce cas, dans chaque ligne Lⱼ de la mémoire tampon 105, le champ DATA2 peut avoir la taille de deux pages P_{i,j} de la mémoire 101, de façon à pouvoir contenir à la fois une nouvelle donnée utilisateur à écrire dans une page de la mémoire, et le résultat de la combinaison entre cette nouvelle donnée et une ancienne donnée, par exemple le résultat du OU EXCLUSIF entre cette nouvelle donnée et une ancienne donnée.

Cette variante de réalisation est notamment avantageuse lorsque les étapes d'écriture dans la mémoire 101 sont plus longues que les étapes de lecture dans la mémoire 101.

Lorsqu'une opération de lecture dans une page P_{i,j} de la mémoire 101 est requise par l'utilisateur, le circuit de contrôle 103 consulte la table de lignes Lⱼ de la mémoire tampon 105, à l'adresse page de la requête utilisateur, c'est-à-dire qu'il consulte la ligne Lⱼ de même rang j dans la table de la mémoire 105 que la page P_{i,j} dans le segment Sᵢ.

Si le champ de validité V de la ligne Lⱼ est à un état valide, et si le champ d'adresse de segment AS de la ligne Lⱼ contient la même adresse de segment que la requête utilisateur, cela signifie que la donnée visée par l'utilisateur se trouve dans la ligne Lⱼ de la mémoire tampon. Le circuit de contrôle 103 détermine alors, en tenant compte le cas échéant des données contenues dans les champs DATA1 et DATA2 de la ligne Lⱼ, la donnée à renvoyer à l'utilisateur et transmet cette donnée à l'utilisateur. Dans l'exemple susmentionné d'application à un mécanisme de réduction de l'usure et/ou de la consommation de la mémoire, la donnée renvoyée à l'utilisateur par le circuit 103 peut être directement la donnée contenue dans le champ DATA2 de la ligne Lⱼ.

Si le champ de validité V de la ligne Lⱼ est à un état valide, et si le champ d'adresse de segment AS de la ligne Lⱼ ne contient pas la même adresse de segment que la requête utilisateur, ou si le champ de validité V de la ligne Lⱼ est à un état invalide, le circuit de contrôle 103 lit la donnée visée directement dans la mémoire 101 et n'écrit pas dans la mémoire tampon 105.

A titre de variante, on peut également, à chaque opération de lecture, stocker la donnée lue dans la mémoire tampon 105 afin que cette donnée puisse ultérieurement être lue une nouvelle fois plus rapidement et avec une plus faible consommation d'énergie dans le cas où les pages de la mémoire sont, statistiquement, appelées à être lues plus souvent qu'elles ne sont écrites.

Pour cela, un deuxième bit ou champ de validité V' (non représenté) est introduit dans chaque ligne Lⱼ de la mémoire tampon 105, qui est initialement à un état invalide et qui est mis à un état valide lorsqu'une nouvelle donnée à écrire provenant d'une requête utilisateur est écrite dans le champ DATA2 de la ligne Lⱼ.

Lorsqu'une opération de lecture dans une page P_{i,j} de la mémoire 101 est requise par l'utilisateur, le circuit de contrôle 103 consulte la table de lignes Lⱼ de la mémoire tampon 105, à l'adresse page de la requête utilisateur.

Si le champ de validité V de la ligne Lⱼ est à l'état valide, et si le champ d'adresse de segment AS de la ligne Lⱼ contient la même adresse de segment que la requête utilisateur, le circuit de contrôle 103 vérifie si le champ de validité V' de la ligne Lⱼ est à l'état valide.

Si le champ V' de la ligne Lⱼ est à l'état valide, le circuit de contrôle 103 procède comme précédemment, c'est-à-dire qu'il détermine, en tenant compte des données contenues dans les champs DATA1 et DATA2 de la ligne Lⱼ, la donnée à renvoyer à l'utilisateur et fournit cette donnée à l'utilisateur.

Si le champ V' de la ligne Lⱼ est à l'état invalide, le circuit de contrôle 103 fournit directement à l'utilisateur la donnée contenue dans le champ DATA1 de la ligne Lⱼ, sans tenir compte de la donnée contenue dans le champ DATA2 de la ligne Lⱼ.

Si le champ de validité V de la ligne Lⱼ est à l'état valide, et si le champ d'adresse de segment AS de la ligne Lⱼ contient une adresse de segment différente de l'adresse de segment de la requête utilisateur, le circuit de contrôle 103 vérifie si le champ de validité V' de la ligne Lⱼ est à l'état valide.

Si le champ V' de la ligne Lⱼ est à l'état valide, cela signifie qu'une étape d'écriture dans la mémoire 101 est en attente. Le circuit de contrôle 103 détermine alors, en tenant compte des données contenues dans les champs DATA1 et DATA2 de la ligne Lⱼ, la donnée à écrire dans la page P_{i',j} de la mémoire 101 dont l'adresse est définie par l'adresse segment contenue dans le champ AS de la ligne Lⱼ et par l'adresse page de la requête utilisateur, puis écrit cette donnée dans la page P_{i',j} via le port PTW. Parallèlement à cette étape d'écriture, le circuit de contrôle 103 lit la donnée contenue dans la page P_{i,j} de la mémoire 101, écrit cette donnée dans le champ DATA1 de la ligne Lⱼ, fournit cette donnée à l'utilisateur, et met le champ V' de la ligne Lⱼ à l'état invalide.

Si le champ V' de la ligne Lⱼ est à l'état invalide, le circuit de contrôle 103 lit la donnée contenue dans la page P_{i,j} de la mémoire 101, écrit cette donnée dans le champ DATA1 de la ligne Lⱼ, fournit cette donnée à l'utilisateur, et laisse le champ V' de la ligne Lⱼ à l'état invalide.

Si le champ V de la ligne Lⱼ est à l'état invalide, le circuit de contrôle 103 lit la donnée contenue dans la page P_{i,j} de la mémoire 101, écrit cette donnée dans le champ DATA1 de la ligne Lⱼ, fournit cette donnée à l'utilisateur, et met le champ V de la ligne Lⱼ à l'état valide et le champ V' de la ligne Lⱼ à l'état invalide.

Lorsqu'une opération d'écriture dans une page P_{i,j} de la mémoire 101 est requise par l'utilisateur, le circuit de contrôle 103 effectue les opérations décrites dans l'exemple précédent et met en outre le bit V' de la ligne Lⱼ à l'état valide.

Dans le cas où la mémoire tampon 105 est une mémoire volatile et où la mémoire principale 101 est une mémoire non volatile, des mécanismes peuvent être prévus pour éviter, à la mise hors tension du système, une éventuelle perte de données qui seraient enregistrées dans la mémoire tampon 105 mais pas encore écrites dans la mémoire principale 101.

A titre d'exemple, avant une coupure d'alimentation, le système utilisateur peut envoyer une instruction d'arrêt au circuit de contrôle 103. Le circuit de contrôle 103 peut alors parcourir toutes les lignes de la mémoire tampon 105 et effectuer les opérations d'écriture dans la mémoire 101 qui n'ont pas encore été effectuées. Dans ce cas, tous les champs de validité V ou V et V' de la mémoire tampon peuvent être initialisés à l'état invalide à chaque mise sous tension du système.

A titre de variante, la mémoire tampon 105 peut être couplée à une mémoire non volatile supplémentaire, non représentée, dans laquelle sont transférées toutes les données contenues dans la mémoire tampon 105 avant une mise hors tension du système. Cette mémoire non volatile supplémentaire peut être incluse ou non dans la mémoire principale 101. Lorsque le système est remis sous-tension, les données de la mémoire non volatile supplémentaire peuvent être retransférées dans la mémoire tampon 105. A titre d'exemple, chaque cellule de stockage de la mémoire tampon 105 peut être couplée à un élément de stockage non volatil, de façon que le contenu de la mémoire 105 puisse être intégralement transféré dans les éléments de stockage non volatils en un seul cycle avant une mise hors-tension du système.

Les champs de validité V ou V et V' de la mémoire tampon 105 sont alors par exemple initialisés à l'état invalide uniquement à la première mise sous tension du système.

On notera que les modes de réalisation décrits ne se limitent pas à l'exemple particulier susmentionné d'utilisation du système de la figure 1 pour la mise en oeuvre d'un mécanisme de réduction de l'usure et/ou de la consommation de la mémoire 101, dans lequel chaque opération d'écriture d'une nouvelle donnée dans la mémoire 101 comprend une étape de lecture d'une ancienne donnée dans la mémoire, suivie d'une étape d'écriture à la même adresse des seules cellules de la mémoire dont l'état doit être modifié pour enregistrer la nouvelle donnée.

Plus généralement, le système 100 de la figure 1 est compatible avec toute application dans laquelle une opération d'écriture d'une nouvelle donnée dans une mémoire, résistive ou d'un autre type, par exemple une mémoire capacitive, comprend une étape de lecture d'une ancienne donnée dans la mémoire, suivie d'une étape d'écriture de la nouvelle donnée, à la même adresse de la mémoire, en tenant compte de l'ancienne donnée.

A titre d'exemple d'application, on considère le cas où, dans chaque page P_{i,j} de la mémoire 101, des cellules élémentaires de la page sont réparties en plusieurs mots M_{i,j,k} (avec k entier allant de 1 à m et m entier supérieur à 1) de plusieurs cellules chacun, par exemple des mots de 32 bits, et d'autres cellules élémentaires de la mémoire sont affectées au stockage de codes de correction d'erreur, par exemple des codes de Hamming, permettant de protéger les données contenues dans les mots de la page contre une éventuelle défaillance d'une cellule de la page, par exemple due à des particules alpha. Dans cet exemple, un même code correcteur d'erreur est affecté à la protection de plusieurs mots de la page (deux ou plus) . Par la suite, par souci de simplification, on considère le cas où chaque page P_{i,j} contient un seul code correcteur d'erreur protégeant l'ensemble des mots de la page. L'homme du métier saura toutefois adapter le fonctionnement décrit au cas où une page contient plusieurs groupes distincts d'au moins deux mots chacun, et un code correcteur d'erreur par groupe.

Lorsque, lors d'une opération d'écriture d'une nouvelle donnée dans une page, l'utilisateur souhaite modifier uniquement une partie des mots de la page, par exemple un seul mot de la page, on pourrait envisager d'écrire la nouvelle donnée utilisateur dans ce mot de la page en une seule étape d'écriture, en désactivant les amplificateurs d'écriture des autres cellules de la page pour ne pas affecter leur contenu. Toutefois, cette solution ne permet pas de mettre à jour le code d'erreur de la page pour tenir compte de la nouvelle donnée écrite.

Ainsi, lors d'une opération d'écriture, on peut prévoir de lire l'ancien contenu de la page, de corriger, le cas échéant ce contenu à l'aide du code correcteur d'erreur de la page, de modifier ce contenu en y insérant la nouvelle donnée utilisateur et en modifiant le code correcteur pour tenir compte de la nouvelle donnée utilisateur, puis d'écrire le nouveau contenu dans la page.

Chaque opération d'écriture d'une nouvelle donnée dans une page comprend donc une étape de lecture d'une ancienne donnée dans la page, suivie d'une étape d'écriture de la nouvelle donnée dans la page en tenant compte de l'ancienne donnée.

On comprend donc que l'utilisation du système 100 de la figure 1 pour réaliser de telles opérations d'écritures permet avantageusement, du point de vue de l'utilisateur, de diminuer les temps d'accès aux données contenues dans la mémoire.

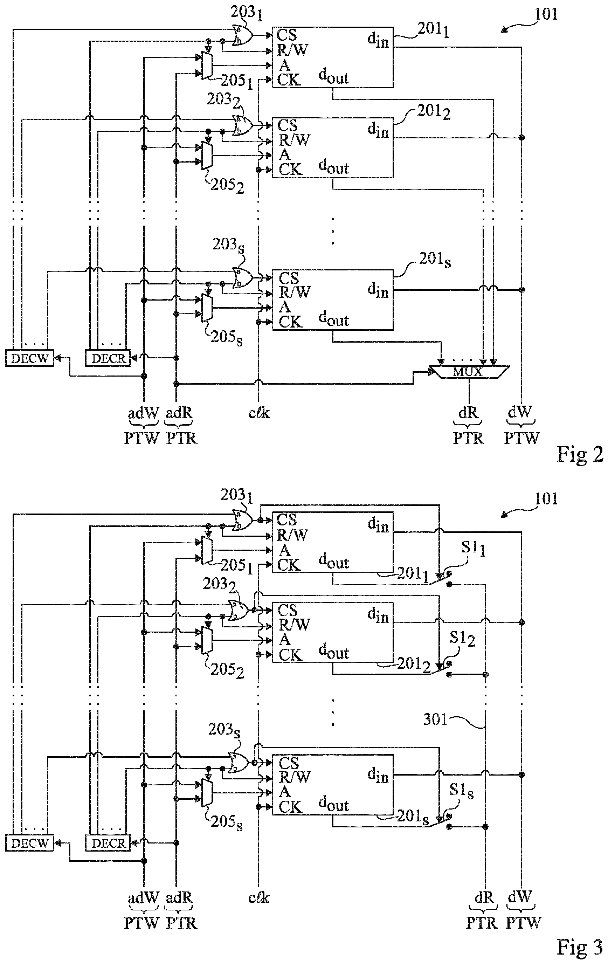

La figure 2 représente de façon schématique et partielle un exemple de réalisation d'une mémoire 101 compatible avec le système de la figure 1. Dans cet exemple, la mémoire 101 comporte une pluralité de portions de mémoire 201ᵢ, avec i entier allant de 1 à s et s entier supérieur à 1, de plusieurs pages (non visibles sur la figure 2) chacune. Dans cet exemple, chaque portion 201ᵢ de la mémoire 101 correspond à un segment Sᵢ de la mémoire.

La mémoire 101 comporte un premier port d'accès PTR permettant d'accéder en lecture aux pages de la mémoire 101, et un deuxième port d'accès PTW permettant d'accéder en écriture aux pages de la mémoire 101, les ports PTR et PTW permettant d'accéder simultanément à deux pages quelconques de la mémoire 101, à condition que ces pages appartiennent à des portions 201ᵢ distinctes de la mémoire.

Par port d'accès, on entend ici un ensemble de bornes d'entrée et/ou sortie adapté à recevoir un signal d'adresse, à recevoir un signal de donnée d'entrée, et/ou à fournir un signal de donnée de sortie. Un port d'accès peut notamment comporter une entrée d'adresse sur plusieurs bits, adaptée à recevoir un signal d'adresse, une entrée de donnée sur plusieurs bits, adaptée à recevoir un signal de donnée à écrire dans la mémoire, et/ou une sortie de donnée sur plusieurs bits, adaptée à fournir un signal de donnée lue dans la mémoire. L'entrée de donnée et la sortie de donnée peuvent éventuellement être confondues. Dans l'exemple de la figure 2, le port d'accès PTR de la mémoire 101 comporte une entrée d'adresse adR adaptée à recevoir une adresse d'une page à lire dans la mémoire, et une sortie de donnée dR adaptée à transmettre le contenu d'une page lue dans la mémoire, et le port d'accès PTW comporte une entrée d'adresse adW adaptée à recevoir une adresse d'une page à écrire dans la mémoire, et une entrée de donnée dW adaptée à recevoir un contenu à écrire dans une page de la mémoire. Dans le cas où un mécanisme de réduction d'usure du type susmentionné est mis en oeuvre, le port d'accès en écriture PTW peut en outre comporter une entrée cmd_{W} (non représentée) de commande des amplificateurs d'écriture de la mémoire, par exemple de la même taille que l'entrée de donnée dW, cette entrée de commande étant adaptée à recevoir une donnée de commande des amplificateurs d'écriture, par exemple le résultat du OU EXCLUSIF entre une nouvelle donnée utilisateur à écrire dans la mémoire via l'entrée dW et une ancienne donnée lue à la même adresse dans la mémoire.

Dans cet exemple, chaque portion de mémoire 201ᵢ comprend une entrée CS adaptée à recevoir un signal d'activation/désactivation de la portion 201ᵢ, une entrée R/W adaptée à recevoir un signal de commande en lecture ou en écriture de la portion 201ᵢ, une entrée CK adaptée à recevoir un signal d'horloge, une entrée A adaptée à recevoir une adresse d'une page de la portion de mémoire 201ᵢ, une entrée dᵢₙ adaptée à recevoir une donnée (de la taille d'une page) à écrire dans la page d'adresse A de la portion de mémoire 201ᵢ, et une sortie dₒᵤₜ adaptée à fournir une donnée (de la taille d'une page) lue dans la page d'adresse A de la portion de mémoire 201ᵢ.

Dans cet exemple, chaque portion 201ᵢ de la mémoire 101 a son entrée d'activation CS reliée à la sortie d'une porte OU 203ᵢ à deux entrées a et b, son entrée de commande de mode de fonctionnement R/W reliée à l'entrée b de la porte OU 203ᵢ, et son entrée de donnée dᵢₙ reliée à l'entrée de donnée dW du port d'accès PTW. Dans le cas où un mécanisme de réduction d'usure du type susmentionné est mis en oeuvre, chaque portion 201ᵢ de la mémoire peut en outre comporter une entrée cmdᵢₙ (non représentée) de commande de ses amplificateurs d'écriture, reliée à l'entrée de commande cmd_{W} (non représentée) du port PTW.

La mémoire 101 comprend un circuit de décodage d'adresse de lecture DECR, comprenant une entrée reliée à l'entrée d'adresse adR du port d'accès PTR de la mémoire et s sorties binaires reliées respectivement aux entrées a des portes OU 203₁ à 203ₛ. La mémoire 101 comprend en outre un circuit de décodage d'adresse d'écriture DECW, comprenant une entrée reliée à l'entrée d'adresse adW du port d'accès PTW de la mémoire et s sorties binaires reliées respectivement aux entrées b des portes OU 203₁ à 203ₛ. Le décodeur DECR est adapté à déterminer dans quelle portion 201ᵢ de la mémoire 101 se trouve le mot adressé par l'entrée d'adresse adR, et à appliquer un signal d'activation sur l'entrée a de la porte OU 203ᵢ reliée à cette portion de mémoire. Le décodeur DECW est adapté à déterminer dans quelle portion 201ᵢ de la mémoire 101 se trouve le mot adressé par l'entrée d'adresse adW, et à appliquer un signal d'activation sur l'entrée b de la porte OU 203ᵢ reliée à cette portion de mémoire. Ainsi, les décodeurs DECR et DECW peuvent activer simultanément deux portions de mémoire 201ᵢ distinctes. En pratique, parmi les bits d'adresse appliqués sur les entrées adR et adW, on peut se contenter de transmettre aux décodeurs DECR et DECW uniquement les bits indiquant les numéros des portions de mémoire dans lesquelles se trouvent les pages adressées.

Dans cet exemple, chaque portion 201ᵢ de la mémoire 101 a son entrée d'adressage A reliée à la sortie d'un multiplexeur 205ᵢ de deux entrées vers une sortie. Chaque multiplexeur 205ᵢ a une première entrée reliée à l'entrée d'adresse adR du port PTR et une deuxième entrée reliée à l'entrée d'adresse adW du port PTW. Dans cet exemple, chaque multiplexeur 205ᵢ a de plus une entrée de sélection reliée à l'entrée b de la porte OU 203ᵢ reliée à la portion de mémoire 201ᵢ. Le fonctionnement des multiplexeurs 205ᵢ est tel que : lorsqu'une portion de mémoire 201ᵢ est activée par le décodeur DECR, l'adresse fournie par le multiplexeur 205ᵢ sur l'entrée A de la portion de mémoire 201ᵢ est celle transmise par l'entrée d'adresse adR ; et lorsqu'une portion de mémoire 201ᵢ est activée par le décodeur DECW, l'adresse fournie par le multiplexeur 205ᵢ sur l'entrée A de la portion de mémoire 201ᵢ est celle transmise par l'entrée d'adresse adW. En pratique, parmi les bits d'adresse transmis par les entrées d'adresse adR et adW, on peut se contenter de transmettre aux multiplexeurs 205ᵢ uniquement les bits définissant la position de la page adressée à l'intérieur de la portion de mémoire 201ᵢ dans laquelle elle se trouve.

Dans cet exemple, la mémoire 101 comprend en outre un multiplexeur MUX de s entrées vers une sortie, dont la sortie est reliée à la sortie de donnée dR du port PTR. Les s entrées du multiplexeur MUX sont reliées respectivement aux s sorties de donnée dₒᵤₜ des s portions 201ᵢ de la mémoire 101. Dans cet exemple, le multiplexeur MUX a une entrée de commande ou de sélection reliée à l'entrée d'adresse adR du port d'accès PTR de la mémoire. Le fonctionnement du multiplexeur MUX est tel que, lorsqu'une portion de mémoire 201ᵢ est activée par le décodeur DECR, la donnée fournie par le multiplexeur MUX sur la sortie de donnée dR est celle fournie par la portion de mémoire 201ᵢ sur sa sortie dₒᵤₜ. En pratique, parmi les bits d'adresse appliqués sur l'entrée d'adresse adR, on peut se contenter de transmettre au multiplexeur MUX uniquement les bits indiquant les numéros des portions de mémoire dans lesquelles se trouvent les pages adressées.

Dans cet exemple, les entrées CK des différentes portions 201ᵢ de la mémoire 101 sont reliées à un même noeud clk d'application d'un signal d'horloge.

A titre d'exemple, les différentes portions 201ᵢ de la mémoire 101, et les éléments 203ᵢ, 205ᵢ, DECR, DECW et MUX peuvent être intégrés dans une même puce semiconductrice.

Un avantage de la mémoire 101 est qu'elle permet des accès simultanés en lecture et en écriture à des mots distincts de la mémoire, tout en présentant un encombrement à peine supérieur à celui d'une mémoire simple port.

La figure 3 représente de façon schématique et partielle un autre exemple de réalisation d'une mémoire 101 compatible avec le système de la figure 1. La mémoire 101 de la figure 3 comprend de nombreux éléments communs avec la mémoire 101 de la figure 2. Ces éléments ne seront pas à nouveau décrits en détail ci-après. Dans la suite, seules les différences entre les mémoires des figures 2 et 3 seront mises en exergue.

La mémoire 101 de la figure 3 comprend, comme dans l'exemple de la figure 2, un premier port d'accès en lecture PTR comportant une entrée adR d'adresse d'une page à lire, et une sortie dR de donnée lue dans une page, et un second port d'accès PTW comportant une entrée adW d'adresse d'une page à écrire, une entrée dW de donnée à écrire dans une page, et, le cas échéant, une entrée cmd_{W} (non représenté) de commande des amplificateurs d'écriture de la mémoire.

De plus, la mémoire 101 de la figure 3 comprend, comme dans l'exemple de la figure 2, une pluralité de portions de mémoire 201ᵢ, avec i entier allant de 1 à s et s entier supérieur à 1, identiques ou similaires à celles de la mémoire de la figure 2.

Dans la mémoire 101 de la figure 3, les mécanismes de sélection des portions 201ᵢ, via les décodeurs DECR et DECW et les portes OU 203ᵢ, les mécanismes d'adressage de page dans les portions 201ᵢ, via les multiplexeurs 205ᵢ, et les mécanismes de fourniture de données d'entrée aux portions 201ᵢ, via l'entrée d'écriture dW, sont identiques ou similaires à ceux de la mémoire de la figure 2, et ne seront pas décrits à nouveau.

La mémoire 101 de la figure 3 diffère de la mémoire de la figure 2 principalement par les circuits utilisés pour multiplexer les sorties de donnée dₒᵤₜ des différentes portions de mémoire 201ᵢ, vers la sortie de donnée dR du port PTR. Dans la mémoire 101 de la figure 3, chaque portion 201ᵢ de la mémoire a sa sortie dₒᵤₜ reliée, par un interrupteur S1ᵢ, à un bus de donnée de sortie 301 relié à la sortie de donnée dR de la mémoire. Dans cet exemple, chaque interrupteur S1ᵢ a un noeud de commande connecté à l'entrée a de la porte OU 203ᵢ reliée à la portion de mémoire 201ᵢ. Lorsqu'une portion de mémoire 201ᵢ est activée en lecture par le décodeur DECR, la sortie de donnée dₒᵤₜ de la portion de mémoire 201ᵢ est reliée à la sortie de donnée dR de la mémoire par fermeture de l'interrupteur S1ᵢ.

Ainsi, dans la mémoire 101 de la figure 3, le multiplexeur MUX de la figure 2 est remplacé par un circuit de multiplexage distribué, réparti au niveau des différentes portions de mémoire 201ᵢ. Les interrupteurs S1ᵢ sont par exemple réalisés par des transistors MOS. Chaque interrupteur S1ᵢ est par exemple disposé au voisinage de la portion de mémoire 201ᵢ de même rang. De plus, le bus de donnée de sortie 301 passe de préférence à proximité des différentes portions de mémoire 201ᵢ.

Un avantage de la variante de réalisation de la figure 3 est qu'elle permet, par rapport à l'exemple de la figure 2, de réduire le nombre de câbles ou pistes reliant les sorties dₒᵤₜ des différentes portions de mémoire 201ᵢ à la sortie de donnée dR de la mémoire (et donc de réduire la surface et le coût de la mémoire).

Des modes de réalisation particuliers ont été décrits. Diverses variantes et modifications apparaîtront à l'homme de l'art.

En particulier, les modes de réalisation décrits ne se limitent pas aux exemples particuliers décrits en relation avec les figures 2 et 3 de mémoires permettant des accès simultanés en lecture et en écriture à des pages distinctes de la mémoire. Les modes de réalisation décrits sont notamment compatibles avec une mémoire double port permettant des accès simultanés en lecture et en écriture à deux pages quelconques de la mémoire (ce qui correspond au cas où chaque segment de la mémoire comprend une seule page). Dans ce cas, la réalisation du système 100 de la figure 1 se trouve simplifiée, notamment du fait que la mémoire tampon 105 de la figure 1 peut être réduite à un registre d'une seule ligne L₁. Dans ce cas, le champ d'adresse segment AS de la ligne L₁ peut contenir la totalité de l'adresse page de la requête utilisateur.

De plus, les modes de réalisation décrits ci-dessus ne se limitent pas aux exemples de moyens et mécanismes décrits en relation avec la figure 1 pour gérer les accès utilisateurs consécutifs à un même segment Sᵢ de la mémoire.

## Revendications

1. Système (100) comportant :
une première mémoire (101) comportant plusieurs portions (Sᵢ, 201ᵢ) de plusieurs pages (P_{i,j}) chacune, cette mémoire (101) comportant des premier (PTR) et deuxième (PTW) ports permettant d'accéder en même temps, respectivement en lecture et en écriture, à deux pages de la mémoire, à condition que ces pages appartiennent à des portions (Sᵢ, 201ᵢ) distinctes de la mémoire (101), chaque portion (Sᵢ, 201ᵢ) de la première mémoire (101) comprenant un unique port d'accès (A, dᵢₙ, dₒᵤₜ) aux pages de la portion, ce port pouvant être connecté à l'un ou l'autre des premier (PTR) et deuxième (PTW) ports de la première mémoire (101) par des circuits de multiplexage (205ⱼ, MUX) ;
un circuit de contrôle (103) adapté à effectuer des opérations d'écriture dans des pages (P_{i,j}) de la mémoire (101), chaque opération d'écriture dans une page (P_{i,j}) de la mémoire (101) comportant une étape de lecture d'une ancienne donnée contenue dans cette page (P_{i,j}), suivie d'une étape d'écriture d'une nouvelle donnée dans cette page (P_{i,j}) via le deuxième port (PTW) en tenant compte de l'ancienne donnée ; le système étant **caractérisé en ce qu'**il comporte en outre:
une deuxième mémoire (105) comportant un nombre (p) de lignes (Lⱼ) égal au nombre (p) de pages (P_{i,j}) d'une portion (Sᵢ, 201ᵢ) de la première mémoire (101), et telle que chacune des lignes (Lⱼ) corresponde à l'adresse d'une page dans la première mémoire, chaque ligne (Lⱼ) de la deuxième mémoire (105) contenant un premier champ (AS), un deuxième champ (DATA1), un troisième champ (DATA2), et un quatrième champ (V), le circuit de contrôle étant adapté à stocker dans le premier champ (AS) une adresse d'une portion (Sᵢ, 201ᵢ) de la première mémoire, à stocker dans le deuxième champ (DATA1) des données lues de la page correspondante de la portion dont l'adresse est indiquée dans le premier champ (AS), à stocker dans le troisième champ (DATA2) des données à écrire dans la page correspondante dont l'adresse est indiquée dans le premier champ (AS), et à stocker dans le quatrième champ (V) un bit de validité,
le circuit de contrôle (103) étant adapté, à chaque opération d'écriture dans une page (P_{i,j}) de la première mémoire (101), à consulter le quatrième champ (V) de la ligne (Lⱼ) dont l'adresse dans la deuxième mémoire (105) correspond à l'adresse de la page (P_{i,j}) visée dans la portion (Sᵢ) à laquelle elle appartient, et, lorsque ce champ (V) est à un état invalide, à lire une ancienne donnée contenue dans la page (Pi,j) visée et écrire cette donnée dans le deuxième champ (DATA1) de la ligne (Lj), à écrire une nouvelle donnée dans le troisième champ (DATA2) de la ligne (Lj), à écrire l'adresse de la portion contenant la page (Pi,j) visée dans le premier champ (AS) de la ligne (Lj), et à mettre le quatrième champ (V) de la ligne (Lj) à un état valide.

2. Système selon la revendication 1, dans lequel le circuit de contrôle (103) est en outre adapté, à chaque opération de lecture ou d'écriture dans une page (P_{i,j}) dans la première mémoire (101) :
à déterminer si le quatrième champ (V) de la ligne (Lⱼ) d'adresse correspondant à l'adresse de la page (P_{i,j}) visée est à un état valide ; et/ou
à comparer le contenu du premier champ (AS) de ladite ligne (Lⱼ) à l'adresse (Sᵢ) de la portion contenant la page (P_{i,j}) visée.

3. Système (100) selon la revendication 1 ou 2, dans lequel la première mémoire (101) est une mémoire résistive.

4. Système (100) selon l'une quelconque des revendications 1 à 3, dans lequel, pour effectuer des première et deuxième opérations d'écriture consécutives dans des première et deuxième pages (P_{i,j}) de portions (Sᵢ, 201ᵢ) distinctes de la première mémoire (101), le circuit de contrôle (103) est adapté à, successivement :
lire une première ancienne donnée dans la première page via le premier port (PTR) et écrire cette donnée dans la deuxième mémoire (105) ;
lire une deuxième ancienne donnée dans la deuxième page via le premier port (PTR) et écrire cette donnée dans la deuxième mémoire (105), et, simultanément, écrire une première nouvelle donnée dans la première page via le deuxième port (PTW) en tenant compte de la première ancienne donnée ; et
écrire une deuxième nouvelle donnée dans la deuxième page via le deuxième port (PTW) en tenant compte de la deuxième ancienne donnée.

5. Système (100) selon l'une quelconque des revendications 1 à 4, dans lequel la deuxième mémoire (105) est une mémoire SRAM.

6. Système (100) selon l'une quelconque des revendications 1 à 5, dans lequel chaque page (P_{i,j}) de la première mémoire (101) comprend plusieurs cellules élémentaires de stockage de données, et dans lequel le circuit de contrôle (103) est adapté, à chaque opération d'écriture d'une nouvelle donnée dans une page (P_{i,j}) de la première mémoire (101), lors de l'étape d'écriture de cette opération d'écriture, à comparer l'ancienne donnée lue dans la page (P_{i,j}) et la nouvelle donnée, et à écrire uniquement dans les cellules de la page (P_{i,j}) dont le contenu doit être modifié pour enregistrer la nouvelle donnée.

7. Système (100) selon l'une quelconque des revendications 1 à 5, dans lequel chaque page (P_{i,j}) de la première mémoire (101) comprend au moins des premier et deuxième mots comportant chacun une ou plusieurs cellules élémentaires de stockage de données, et un ensemble d'une ou plusieurs cellules élémentaires de stockage de données adapté à contenir un code de correction d'erreur protégeant des données contenues dans les premier et deuxième mots.

8. Système (100) selon la revendication 7, dans lequel le circuit de contrôle (103) est adapté, à chaque opération d'écriture dans une page (P_{i,j}) de la mémoire (101), à lire dans la page (P_{i,j}) une ancienne donnée comportant les contenus des premier et deuxième mots de la page (P_{i,j}) et le code de correction d'erreur les protégeant, à corriger si nécessaire les contenus des premier et deuxième mots à l'aide du code de correction d'erreur, à remplacer dans l'ancienne donnée le contenu d'au moins un des premier et deuxième mots par la nouvelle donnée utilisateur, à recalculer le code de correction d'erreur pour tenir compte de la nouvelle donnée utilisateur, puis à écrire dans la page (P_{i,j}) la nouvelle donnée et le nouveau code de correction d'erreur.

## Patentansprüche

1. Ein System (100), welches folgendes aufweist:
einen ersten Speicher (101), der eine Vielzahl von Teilen (Sᵢ, 201ᵢ) mit jeweils einer Vielzahl von Seiten (P_{i,j}) aufweist, wobei der Speicher (101) erste (PTR) und zweite (PTW) Anschlüsse besitzt, die simultanen Zugriff im Lese- bzw. Schreibmodus vorsehen zu zwei Seiten des Speichers, vorausgesetzt, dass diese Seiten zu unterschiedlichen Teilen (Sᵢ, 201ᵢ) des Speichers (101) gehören, wobei jeden Teil (Sᵢ, 201ᵢ) des ersten Speichers (101) einen einzigen Zugriffsanschluss (A, dᵢₙ, dₒᵤₜ) aufweisen zu den Seiten des Teiles, wobei dieser Anschluss in der Lage ist mit einem oder dem anderen der ersten (PTR) und zweiten (PTW) Anschlüsse des ersten Speichers (101) verbunden zu werden, und zwar durch Multiplexschaltungen (205ⱼ, MUX);
eine Steuerschaltung (103), die in der Lage ist Schreiboperationen in den Seiten (P_{i,j}) des Speichers (101) auszuführen, wobei jede Schreiboperation in einer Seite (P_{i,j}) des Speichers (101) einen Schritt des Lesens alter Daten enthalten in dieser Seite (P_{i,j}) aufweist, und zwar gefolgt von einem Schritt des Schreibens neuer Daten in diese Seite (P_{i,j}) über den zweiten Anschluss (PTW), während die alten Daten berücksichtigt werden;
das System ist **gekennzeichnet dadurch, dass** es weiterhin folgendes aufweist:
einen zweiten Speicher (105), der eine Anzahl (p) von Zeilen (Lⱼ) gleich der Anzahl (p) der Seiten (P_{i,j}) eines Teiles (Sᵢ, 201ᵢ) des ersten Speichers (101) aufweist und derart dass jede Zeile (Lⱼ) des zweiten Speichers einer Adresse einer Seite in dem ersten Speicher entspricht, wobei jede Zeile (Lⱼ) des zweiten Speichers (105) ein erstes Feld (AS), ein zweites Feld (DATA1), ein drittes Feld (DATA2) und ein viertes Feld (V) aufweist, wobei die Steuerschaltung in der Lage ist, in dem ersten Feld (AS) eine Adresse eines Teils (Sᵢ, 201ᵢ) des ersten Speichers zu speichern, in dem zweiten Feld (DATA1) Daten gelesen aus der entsprechenden Seite des Teils, deren Adressen in dem ersten Feld (AS) gespeichert sind, zu speichern, in dem dritten Feld (DATA2) Daten, die eingeschrieben werden sollen in der entsprechenden Seite des Teils, dessen Adresse in dem ersten Feld (AS) gespeichert sind, zu speichern, und ferner in dem vierten Feld (V) ein validity bit zu speichern,
die Steuerschaltung (103) ist in der Lage für jede Schreiboperation in eine Seite (P_{i,j}) des ersten Speichers (101) das vierte Feld (V) der Zeile (Lⱼ) zu konsultieren, die ihre Adresse in dem zweiten Speicher (105) entsprechend der Adresse der Zielseite (P_{i,j}) besitzt, und zwar in dem Teil (Sᵢ) zu dem sie gehört, und, wenn dieses vierte Feld (V) sich in einem ungültigen Zustand befindet, alte Daten zu lesen, die in der Zielseite (P_{i,j}) sind, und diese Daten in das zweite Feld (DATA1) der Zeile (Lⱼ) einzuschreiben, um neue Daten in das dritte Feld (DATA2) der Zeile (Lⱼ) einzuschreiben, um die Adresse des Teils, der die Zielseite (P_{i,j}) enthält in das erste Feld (AS) der Zeile (Lⱼ) einzuschreiben, und um das vierte Feld (V) der Zeile (Lⱼ) in einen gültigen Zustand einzustellen.

2. Das System nach Anspruch 1, wobei die Steuerschaltung (103) ferner in der Lage ist für jede Lese- oder Schreiboperation in eine Seite (P_{i,j}) des ersten Speichers (101) folgendes vorzusehen:
Bestimmen, ob das vierte Feld (V) der Adressenzeile (Lⱼ) die Adresse der Zielseite (P_{i,j}) in einem gültigen Zustand ist; und/oder
Vergleichen des Inhalts des ersten Feldes (AS) der erwähnten Zeile (Lⱼ) mit der Adresse (Sᵢ) des Teils, der die Zielseite (P_{i,j}) enthält.

3. Das System (100) nach Anspruch 1 oder 2, wobei der erste Speicher (101) ein Widerstandsspeicher ist.

4. Das System (100) nach einem der Ansprüche 1 bis 3, wobei zur Durchführung der ersten und zweiten aufeinanderfolgenden Schreibvorgänge in ersten und zweiten Seiten (P_{i,j}) unterschiedlicher Teile (Sᵢ, 201ᵢ) des Feldspeichers (101), die Steuerschaltung (103) in der Lage ist, darauffolgend:
die ersten alten Daten von der ersten Seite zu lesen, und zwar über den ersten Anschluss (PTR) und diese Daten in den zweiten Speicher (105) einzuschreiben;
die zweiten alten Daten aus der zweiten Seite über den ersten Anschluss (PTR) zu lesen und diese Daten in den zweiten Speicher (105) einzuschreiben und gleichzeitig die ersten neuen Daten in die erste Seite einzuschreiben, und zwar über den zweiten Anschluss (PTW), während die ersten alten Daten berücksichtigt werden; und
Schreiben der zweiten neuen Daten in die zweite Seite über den zweiten Anschluss (PTW), während die zweiten alten Daten berücksichtigt werden.

5. Das System (100) nach einem der Ansprüche 1 bis 4, wobei der zweite Speicher (105) ein SRAM ist.

6. Das System (100) nach einem der Ansprüche 1 bis 5, wobei jede Seite (P_{i,j}) des ersten Speichers (101) eine Vielzahl von elementaren Datenspeicherzellen aufweist und wobei die Steuerschaltung (103) in der Lage ist, für jede Schreiboperation neuer Daten in eine Seite (P_{i,j}) des ersten Speichers (101), während des Schrittes dieser Schreiboperation, in der Lage ist, alle alten gelesenen Daten von der Seite (P_{i,j}) mit den neuen Daten zu vergleichen, und nur in die Zellen der Seite (P_{i,j}) die Daten einzuschreiben, die einen Inhalt besitzen, der modifiziert ist, um die neuen Daten aufzuzeichnen.

7. Das System (100) nach einem der Ansprüche 1 bis 5, wobei jede Seite (P_{i,j}) des ersten Speichers (101) mindestens erste und zweite Worte aufweisen, wobei jedes eine oder eine Vielzahl von Elementardatenspeicherzellen aufweist, und wobei eine Anordnung von einer oder einer Vielzahl jeder elementaren Speicherzellen in der Lage ist, Fehlerverbindungscodeschutzdaten zu enthalten, und zwar enthalten in den ersten und zweiten Worten.

8. Das System (100) nach Anspruch 7, wobei die Steuerschaltung (103) in der Lage ist für jede Schreiboperation in eine Seite (P_{i,j}) des Speichers (101) folgendes vorzusehen,
Lesen von alten Daten aus der Seite (P_{i,j}), die die Inhalte der ersten und zweiten Worte der Seite (P_{i,j}) aufweisen, und den Fehlerkorrekturcode, der diese schützt, Korrektur, wenn notwendig, der Inhalte der ersten und zweiten Worte durch den Fehlerkorrekturcode,
Ersetzen in den alten Daten den Inhalt von mindestens einem der ersten und zweiten Worte mit den neuen Nutzerdaten,
Rekalkulieren des Fehlerkorrekturcodes zur Berücksichtigung der neuen Nutzerdaten, und sodann Schreiben der neuen Daten und des neuen Fehlerkorrekturcodes in die Seite (P_{i,j}).

## Claims

1. A system (100) comprising:
a first memory (101) comprising a plurality of portions (Sᵢ, 201ᵢ) of a plurality of pages (P_{i,j}) each, the memory (101) comprising first (PTR) and second (PTW) ports providing simultaneous access, respectively in read and in write mode, to two pages of the memory, provided for these pages to belong to different portions (Sᵢ, 201ᵢ) of the memory (101), each portion (Sᵢ, 201ᵢ) of the first memory (101) comprising a single port of access (A, dᵢₙ, dₒᵤₜ) to the pages of the portion, this port being capable of being connected to one or the other of the first (PTR) and second (PTW) ports of the first memory (101) by multiplexing circuits (205ⱼ, MUX);
a control circuit (103) capable of carrying out write operations in pages (P_{i,j}) of the memory (101), each write operation in a page (P_{i,j}) of the memory (101) comprising a step of reading old data contained in this page (P_{i,j}), followed by a step of writing new data into this page (P_{i,j}) via the second port (PTW) while taking into account the old data;
the system being **characterized in that** it further comprises:
a second memory (105) comprising a number (p) of lines (Lⱼ) equal to the number (p) of pages (P_{i,j}) of a portion (Sᵢ, 201ᵢ) of the first memory (101), and such that each line (Lⱼ) of the second memory corresponds to an address of a page in the first memory,_each line (Lⱼ) of the second memory (105) containing a first field (AS), a second field (DATA1), a third field (DATA2), and a fourth field (V), the control circuit is capable to store in the first field (AS) an address of a portion (Sᵢ, 201ᵢ) of the first memory, to store in the second field (DATA1) data read from the corresponding page of the portion whose address is stored in the first field (AS), to store in the third field (DATA2) data to be written in the corresponding page of the portion whose address is stored in the first field (AS), and to store in the fourth field (V) a validity bit,
the control circuit (103) being capable, for each write operation in a page (P_{i,j}) of the first memory (101), of consulting the fourth field (V) of the line (Lⱼ) having its address in the second memory (105) corresponding to the address of the targeted page (P_{i,j}) in the portion (Sᵢ) to which it belongs, and, when this fourth field (V) is in an invalid state, to read and old data contained in the targeted page (P_{i,j}) and write this data in the second field (DATA1) of the line (Lj), to write a new data in the third field (DATA2) of the line (Lj), to write the address of the portion containing the targeted page (P_{i,j}) in the first field (AS) of the line (Lⱼ), and to set the fourth field (V) of the line (Lⱼ) to a valid state.

2. The system of claim 1, wherein the control circuit (103) is further capable, for each read or write operation in a page (P_{i,j}) of the first memory (101), of:
determining whether the fourth field (V) of the address line (Lⱼ) corresponding to the address of the targeted page (P_{i,j}) is in a valid state; and/or
comparing the content of the first field (AS) of said line (Lⱼ) with the address (Sᵢ) of the portion containing the targeted page (P_{i,j}).

3. The system (100) of claim 1 or 2, wherein the first memory (101) is a resistive memory.

4. The system (100) of any of claims 1 to 3, wherein, to perform first and second consecutive write operations in first and second pages (P_{i,j}) of different portions (Sᵢ, 201ᵢ) of the first memory (101), the control circuit (103) is capable of, successively:
reading first old data from the first page via the first port (PTR) and writing these data into the second memory (105);
reading second old data from the second page via the first port (PTR) and writing these data into the second memory (105) and, simultaneously, writing first new data into the first page via the second port (PTW) while taking into account the first old data; and
writing second new data into the second page via the second port (PTW) while taking into account the second old data.

5. The system (100) of any of claims 1 to 4, wherein the second memory (105) is a SRAM.

6. The system (100) of any of claims 1 to 5, wherein each page (P_{i,j}) of the first memory (101) comprises a plurality of elementary data storage cells, and wherein the control circuit (103) is capable, for each operation of writing new data into a page (P_{i,j}) of the first memory (101), during the writing step of this write operation, of comparing the old data read from the page (P_{i,j}) with the new data, and of only writing into the cells of the page (P_{i,j}) having a content to be modified in order to record the new data.

7. The system (100) of any of claims 1 to 5, wherein each page (P_{i,j}) of the first memory (101) comprises at least first and second words, each comprising one or a plurality of elementary data storage cells, and an assembly of one or a plurality of elementary data storage cells capable of containing an error connection code protecting data contained in the first and second words.

8. The system (100) of claim 7, wherein the control circuit (103) is capable, for each operation of writing into a page (P_{i,j}) of the memory (101), of reading from the page (P_{i,j}) old data comprising the contents of the first and second words of the page (P_{i,j}) and the error correction code protecting them, of correcting if necessary the contents of the first and second words by means of the error correction code, of replacing in the old data the content of at least one of the first and second words with the new user data, of recalculating the error correction code to take into account the new user data, and then of writing into the page (P_{i,j}) the new data and the new error correction code.
